# EUROPÄISCHE PATENTSCHRIFT

(11) **EP 3 358 683 B1**
(45) Veröffentlichungstag und Bekanntmachung des Hinweises auf die Patenterteilung: **01.07.2020**
(21) Anmeldenummer: 17154824.1
(22) Anmeldetag: 06.02.2017
(51) Int. Cl.: H01R 13/66

(54) **ELEKTRISCHE STECKKUPPLUNGSVORRICHTUNG IN DEREN GEHÄUSE EIN ELEKTRONISCHES BAUTEIL ANGEORDNET IST.**
ELECTRIC PLUG-IN CONNECTOR DEVICE COMPRISING A CONNECTOR HOUSING COMPRISING AN ELECTRONIC COMPONENT
ACCOUPLEMENT ENFICHABLE ÉLECTRIQUE COMPORTANT UN BOÎTIER DE CONNECTEUR, COMPORTANT UNE COMPOSANTE ÉLECTRONIQUE

(43) Veröffentlichungstag der Anmeldung: 08.08.2018
(73) Patentinhaber: MD Elektronik GmbH, 84478 Waldkraiburg (DE)
(72) Erfinder: HOFMANN, Thomas, 83342 Tacherting (DE); ENGL, Rudolf, 84539 Ampfing (DE); KAASERER, Markus, 83543 Rott am Inn (DE); BOCK, Daniel, 84573 Schönberg (DE); HERMES, Jens, 84427 Sankt Wolfgang (DE)

(56) Entgegenhaltungen:
- EP-A1- 2 003 741
- EP-A1- 2 916 636
- DE-B3-102012 022 004
- US-A1- 2016 192 541
- US-A1- 2016 329 672

## Beschreibung

Die Erfindung betrifft eine elektrische Steckkupplungsvorrichtung gemäß dem Anspruch 1, welche insbesondere als Teil eines konfektionierten Kabels zur Übertragung von elektrischen Strömen, beispielsweise zum Aufladen von Ackumulatoren, geeignet ist.

### GEBIET DER TECHNIK

Die betreffenden elektrischen Steckkupplungsvorrichtungen sind etwa im Zusammenhang mit Kabeln in Kraftfahrzeugen oder Luftfahrzeugen einsetzbar und werden meist in großen Stückzahlen benötigt. Zur kostengünstigen Bereitstellung entsprechender Kabel sind ein einfacher Aufbau und eine einfache Konfektionierbarkeit der elektrischen Steckkupplungsvorrichtungen von großer Bedeutung. Andererseits sind Bestrebungen im Gange, dass in die Steckkupplungsvorrichtungen elektronische Schaltungen, insbesondere elektronische Bauteile auf Leiterplatten, integriert werden. Beispielsweise können derartige Schaltungen als Ladeelektronik ausgestaltet sein zum Aufladen von Akkumulatoren, die mit der elektrischen Steckkupplungsvorrichtungen verbunden sind. Es ist wichtig, dass die Steckkupplungsvorrichtungen durch die innerhalb der Steckkupplungsvorrichtungen erzeugte Abwärme thermisch nicht zu stark belastet werden.

### STAND DER TECHNIK

Die Offenlegungsschrift EP 2 916 636 A1 offenbart eine elektronische Vorrichtung, die ein Gehäuse mit einer Öffnung aufweist. Zur Ableitung der Wärme wird in der Öffnung ein Metallkörper platziert.

Im Dokument EP 2 003 741 A1 wird eine Steckeranordnung beschrieben, die thermoplastische Halbschalen mit einer Nickelbeschichtung aufweist. Auf diese Weise soll eine geschirmte Subminiatur-Verbindungsbaugruppe erhalten werden.

In der US 2016/0192541 A1 wird ein Gehäuse für eine elektronische Vorrichtung gezeigt, bei der die Abwärme von elektronischen Bauteilen ausdrücklich nicht zu den Wänden des Gehäuses übertragen wird. Vielmehr wird dort die Abwärme über ein so genanntes dissipation board aus Metall, das in einer Öffnung des Gehäuses angeordnet ist, direkt an die Umgebung abgegeben.

Zudem ist in der Offenlegungsschrift US 2016/0329672 A1 ein Stecker zum Aufladen von elektronischen Geräten offenbart, wobei der Stecker in seinem Gehäuse eine Leiterplatte mit elektronischen Bauteilen aufweist.

Aus der Patentschrift US 6851869 B2 ist eine Steckkupplungsvorrichtung bekannt, die ein Gehäuse aufweist, welches zur Ableitung von Wärme aus thermisch leitfähigem Polymer-Material hergestellt ist.

### ZUSAMMENFASSUNG DER ERFINDUNG

Der Erfindung liegt die Aufgabe zugrunde, eine elektrische Steckkupplungsvorrichtung zu schaffen, welche vor übermäßiger Eigenerwärmung geschützt ist und dennoch mit relativ geringem Herstellungsaufwand fertigbar ist.

Diese Aufgabe wird erfindungsgemäß durch die Merkmale des Anspruches 1 gelöst.

Erfindungsgemäß umfasst die elektrische Steckkupplungsvorrichtung ein Gehäuse und eine Leiterplatte. Das Gehäuse umfasst seinerseits ein Kunststoffteil mit einer Tasche. Das Kunststoffteil weist eine innere Oberfläche und eine äußere Oberfläche auf. Zumindest an der äußeren Oberfläche ist eine erste Metallschicht aufgebracht. Die Leiterplatte ist im Gehäuse angeordnet und mit zumindest einem elektronischen Bauteil bestückt. Die erste Metallschicht weist in einem ersten Flächenbereich eine erste Schichtdicke und in einem zweiten Flächenbereich eine zweite Schichtdicke auf. Der zweite Flächenbereich ist in der Tasche angeordnet und die zweite Schichtdicke ist größer als die erste Schichtdicke. Das elektronische Bauteil ist so im Gehäuse angeordnet, dass dieses insbesondere ohne Luftspalt mit dem zweiten Flächenbereich thermisch verbunden ist und eine Gerade mit relativ zur Leiterplatte orthogonalem Verlauf sowohl das elektronische Bauteil als auch den zweiten Flächenbereich schneidet.

Unter dem Begriff Tasche ist im Folgenden insbesondere eine Mulde, eine Eintiefung oder ein Rücksprung in der Geometrie des Gehäuses beziehungsweise des Kunststoffteils zu verstehen. Mit anderen Worten ausgedrückt ist der Abstand zwischen der Leiterplatte und der äußeren Oberfläche des Kunststoffteils im Bereich der Tasche kleiner als in einem der Tasche benachbarten Bereich des Kunststoffteils. Somit ist der Abstand zwischen der Leiterplatte und dem zweiten Flächenbereich kleiner als der Abstand zwischen Leiterplatte und dem ersten Flächenbereich.

Als innere Oberfläche des Kunststoffteils des Gehäuses ist insbesondere diejenige Oberfläche zu verstehen, die zur Leiterplatte hin gerichtete ist, beziehungsweise dessen Flächennormale zur Leiterplatte weist. Die äußere Oberfläche weist demgemäß bezogen auf das Gehäuse nach außen.

Mit Vorteil beträgt die erste Schichtdicke der ersten Metallschicht im ersten Flächenbereich zwischen 20 µm und 30 µm und die zweite Schichtdicke im zweiten Flächenbereich zwischen 25 µm und 40 µm.

Mit Vorteil ist die zweite Schichtdicke mindestens 1,1-mal größer als die erste Schichtdicke in besonders vorteilhafterweise mindestens 1,25-mal größer als die erste Schichtdicke oder mindestens 1,3-mal größer als die erste Schichtdicke.

Das elektronische Bauteil ist insbesondere derart mit dem zweiten Flächenbereich thermisch verbunden, dass der Wärmewiderstand zwischen dem elektronischen Bauteil und dem zweiten Flächenbereich kleiner ist als 30 K/W, insbesondere kleiner als 20 K/W, mit Vorteil kleiner als 8 K/W.

In vorteilhafter Bauweise ist an der inneren Oberfläche des Gehäuses in einem dritten Flächenbereich eine zweite Metallschicht aufgebracht, welche so angeordnet ist, dass die Gerade auch den dritten Flächenbereich schneidet.

In weiterer Ausgestaltung der Erfindung ist das elektronische Bauteil ohne Luftspalt mit der inneren Oberfläche des Gehäuses im dritten Flächenbereich thermisch verbunden.

Mit Vorteil ist zur thermischen Anbindung des elektronischen Bauteils eine Wärmeleitpaste zwischen dem elektronischen Bauteil und der inneren Oberfläche des Gehäuses angeordnet. Alternativ kann das elektronische Bauteil unmittelbar die innere Oberfläche des Gehäuses berühren, wobei bei dieser Ausgestaltung insbesondere die Berührung durch eine mechanische Vorspannung zwischen dem Gehäuse und dem elektronischen Bauteil erzeugt werden kann.

In vorteilhafter Bauweise weist das Gehäuse eine Ausnehmung auf, die mit thermisch leitfähigem Material ausgefüllt ist, welches so angeordnet ist, dass die Gerade das thermisch leitfähige Material schneidet.

In weiterer Ausgestaltung der Erfindung ist die elektrische Steckkupplungsvorrichtung so ausgebildet, dass das thermisch leitfähige Material das Kunststoffteil vollständig durchdringt.

Die erste und / oder die zweite Metallschicht kann insbesondere galvanisch aufgebracht sein. Insbesondere kann die erste Metallschicht galvanisch aufgebracht sein, während die zweite Metallschicht als Plättchen am Kunststoffteil befestigt ist.

Mit Vorteil ist die elektrische Steckkupplungsvorrichtung so ausgebildet, dass der zweite Flächenbereich parallel zur Leiterplatte verläuft.

In weiterer Ausgestaltung der Erfindung verläuft (auch) der dritte Flächenbereich parallel zur Leiterplatte.

Besonders vorteilhaft ist die Erfindung, wenn das elektronische Bauteil ein Spannungsregler ist, durch den eine Eingangsspannung auf eine niedrigere Ausgangsspannung regelbar ist, insbesondere zum Laden eines an die Steckkupplungsvorrichtung anschließbaren Akkumulators. Gerade in diesem Fall ist es erforderlich erhebliche Mengen an Verlustwärme an die Umgebung abzuführen um eine Überhitzung der Steckkupplungsvorrichtung insbesondere des Spannungsreglers zu vermeiden.

Vorteilhafte Ausbildungen der Erfindung entnimmt man den abhängigen Ansprüchen.

Weitere Einzelheiten und Vorteile der erfindungsgemäßen Steckkupplungsvorrichtung ergeben sich aus der nachfolgenden Beschreibung von Ausführungsbeispielen anhand der beiliegenden Figuren.

### KURZE BESCHREIBUNG DER ZEICHNUNGEN

Es zeigen die
- Figur 1: eine Längsschnittdarstellung einer Steckkupplungsvorrichtung,
- Figur 2: eine perspektivische Ansicht der Steckkupplungsvorrichtung,
- Figur 3: eine Detailansicht der Steckkupplungsvorrichtung in einer Schnittdarstellung,
- Figur 4: eine Detailansicht der Steckkupplungsvorrichtung in einer Schnittdarstellung nach einem zweiten Ausführungsbeispiel.

### BESCHREIBUNG DER AUSFÜHRUNGSFORMEN

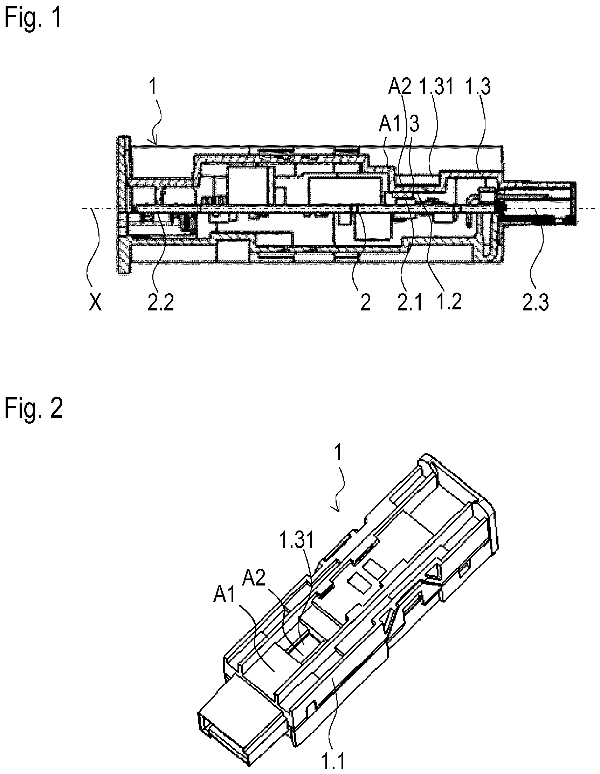

Die im vorgestellten Ausführungsbeispiel beschriebene elektrische Stecckupplungsvorrichtung umfasst eine ebene Leiterplatte 2 gemäß der Figur 1. Zur Herstellung einer elektrischen Verbindung mit einem Gegenstück der Steckkupplungsvorrichtung sind an der Leiterplatte 2 Kontakte 2.2 angeordnet beziehungsweise montiert. Die Orientierung der Kontakte 2.2 ist derart, dass ein Herstellen oder Lösen der betreffenden Steckverbindung parallel zu einer Achse X bestimmungsgemäß erfolgen kann. Die Kontakte 2.2 sind elektrisch mit einer Schaltung verbunden, die unter anderem ein elektronisches Bauteil 2.1 umfasst, wobei das Bauteil 2.1 auf der Leiterplatte 2 angeordnet ist beziehungsweise die Leiterplatte 2 mit dem elektronischen Bauteil 2.2 bestückt ist. Weiterhin umfasst die Leiterplatte 2 einen Eingangskontakt 2.3, welcher mit Leitungen eines Kabels verbindbar ist. Die Steckkupplungsvorrichtung ist insbesondere so ausgestaltet, dass dieses als Ladebuchse zum Aufladen eines Akkumulators eines Endgerätes ausgebildet ist. Demgemäß ist das elektronische Bauteil 2.1 als Spannungsregler ausgebildet, der beispielsweise die Spannung eines Bordnetzes eines Kraftfahrzeuges auf einen Ausgangsspannung von etwa 5 V herunterregelt. Bei diesem Vorgang wird Verlustwärme frei.

Ferner umfasst die elektrische Steckkupplungsvorrichtung ein Gehäuse 1 gemäß der Figur 2, in welchem die Leiterplatte 2 mit dem elektronischen Bauteil 2.1 angeordnet ist.

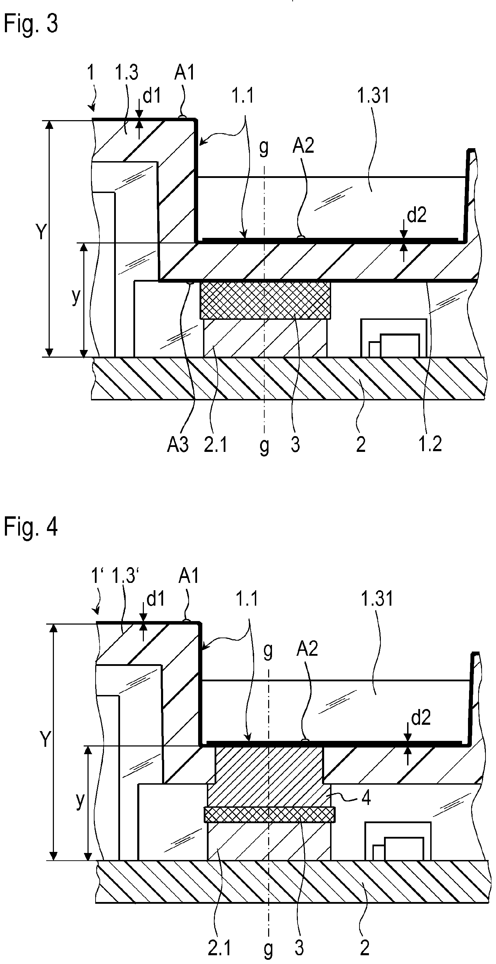

Das Gehäuse 1 umfasst ein Kunststoffteil 1.3, das eine äußere Oberfläche und eine innere Oberfläche aufweist, wobei zumindest an der äußeren Oberfläche eine erste Metallschicht 1.1 und an der inneren Oberfläche eine zweite Metallschicht 1.2, insbesondere durch einen Galvanisierungsprozess, aufgebracht ist (Figur 3). Alternativ können hier auch Metallplättchen montiert werden.

Weiterhin weist das Kunststoffteil 1.3 eine Tasche 1.31 auf. Der Abstand y zwischen der Leiterplatte 2 beziehungsweise deren Oberfläche und der äußeren Oberfläche des Kunststoffteils 1.3 im Bereich der Tasche 1.31 ist kleiner als der Abstand Y in einem der Tasche 1.31 benachbarten Bereich des Kunststoffteils 1.3.

Die erste Metallschicht 1.1 auf der äußeren Oberfläche weist einen ersten Flächenbereich A1 und einen zweiten Flächenbereich A2 auf, wobei der zweite Flächenbereich A2 in der Tasche 1.31 parallel zur Leiterplatte 2 angeordnet ist. Die erste Metallschicht 1.1 weist im ersten Flächenbereich A1 eine erste Schichtdicke d1 und im zweiten Flächenbereich A2 eine zweite Schichtdicke d2 auf. Die zweite Schichtdicke d2 ist größer als die erste Schichtdicke d1. Im vorgestellten Ausführungsbeispiel beträgt die erste Schichtdicke d1 = 20 µm und die zweite Schichtdicke d2 = 25 µm (d2/d1 = 1,25).

Gemäß der Figur 3 weist die zweite Metallschicht 1.2 auf der inneren Oberfläche einen dritten Flächenbereich A3 auf, wobei hier die zweite Metallschicht 1.2 eine Dicke von 25 µm aufweist. Vor dem Zusammenbau der Steckkupplungsvorrichtung wird auf das elektronische Bauteil 2.1 Wärmeleitpaste 3 aufgetragen. Im zusammengebauten Zustand liegt eine Anordnung vor, bei der eine Gerade g, die relativ zur Leiterplatte 2 orthogonal verläuft, sowohl das elektronische Bauteil 2.1 als auch den zweiten Flächenbereich A2 schneidet. Im vorgestellten Ausführungsbeispiel verläuft im Übrigen die Gerade g auch orthogonal zu Achse X. Weiterhin berührt die Wärmeleitpaste 3 das elektronische Bauteil 2.1 und die zweite Metallschicht 1.2 der inneren Oberfläche im dritten Flächenbereich A3. Dadurch dass, das Kunststoffteil 1.3 insbesondere im Bereich der Tasche 1.31 eine vergleichsweise dünne Wandstärke aufweist, kann Wärme mit relativ wenig thermischen Widerstand zwischen der zweiten Metallschicht 1.2 auf der inneren Oberfläche zur ersten Metallschicht 1.1 auf der äußeren Oberfläche fließen, insbesondere zwischen dem dritten Flächenbereich A3 und dem zweiten Flächenbereich A2. Zur Verminderung des Wärmedurchlasswiderstandes kann das Kunststoffteil 1.3 eine erhöhte Wärmeleitfähigkeit aufweisen, beispielsweise durch Zugabe von thermisch leitfähigen Füllstoffen in das Ausgangsmaterial des Kunststoffteils 1.3.

Im Ergebnis ist im vorgestellten Ausführungsbeispiel das elektronische Bauteil 2.1 so im Gehäuse 1 angeordnet, dass dieses ohne Luftspalt mit dem zweiten Flächenbereich A2 thermisch verbunden ist.

Die elektrische Steckkupplungsvorrichtung wird bestimmungsgemäß mit einer elektrischen Leitung verbunden, so dass ein konfektioniertes Kabel hergestellt ist. Derartige Kabel dienen üblicherweise zur Übertragung von elektrischer Energie. Das Kabel ist insbesondere zum Einbau in einem Fahrzeug bestimmt und ist gemäß dem Ausführungsbeispiel zum Laden eines externen Akkus, etwa in einem mobilen Gerät, bestimmt.

Im Betrieb der Steckkupplungsvorrichtung erzeugt das elektronische Bauteil 2.1 Verlustwärme, die im Wesentlichen über die thermisch leitfähige Wärmeleitpaste 3 zur zweiten Metallschicht 1.2 auf der inneren Oberfläche fließt. Dadurch wird auf der äußeren Oberfläche die erste Metallschicht 1.1 im zweiten Flächenbereich A2 erwärmt. Der zweite Flächenbereich A2 gibt einerseits einen Teil der Wärme unmittelbar an die Umgebung ab und einen anderen Teil der Wärme an den ersten Flächenbereich A1 der ersten Metallschicht 1.1, über den dann wiederum Wärme an die Umgebung abfließt.

Auf diese Weise kann eine übermäßige thermische Belastung der Leiterplatte 2 beziehungsweise des elektronischen Bauteils 2.1 vermieden werden.

Gemäß der Figur 4 ist ein zweites Ausführungsbeispiel beschrieben. Dort weist ein Gehäuse 1' ein Kunststoffteil 1.3' mit einer Ausnehmung auf. Die Ausnehmung ist mit thermisch leitfähigem Material 4 ausgefüllt, beispielsweise durch einen Beschichtungsprozess oder in Form eines Stahl-, Aluminium- oder Kupferniets. Das so ausgestaltete Kunststoffteil 1.3' wird einem Beschichtungsprozess unterworfen, so dass wiederum an dessen äußeren Oberfläche die erste Metallschicht 1.1 entsteht, die im Wesentlichen analog zu derjenigen des ersten Ausführungsbeispiels ausgestaltet ist und demnach auch zwei Flächenbereiche A1, A2 unterschiedlicher Dicke d1, d2 aufweist.

Das thermisch leitfähige Material 4 ist so angeordnet, dass die Gerade g auch dieses schneidet. Somit fließt in diesem Ausführungsbeispiel die vom elektronischen Bauteil 2.1 erzeugte Verlustwärme über die Wärmeleitpaste 3 zum thermisch leitfähigen Material 4 und dann in den zweiten Flächenbereich A2 der ersten Metallschicht 1.1 auf der äußeren Oberfläche des Gehäuses 1', insbesondere der Tasche 1.31.

## Patentansprüche

1. Elektrische Steckkupplungsvorrichtung umfassend ein Gehäuse (1; 1') und eine Leiterplatte (2), wobei
- das Gehäuse (1; 1') ein Kunststoffteil (1.3; 1.3') umfasst, das eine innere Oberfläche und eine äußere Oberfläche aufweist,
- die Leiterplatte (2) mit zumindest einem elektronischen Bauteil (2.1) bestückt ist und im Gehäuse angeordnet ist,
- wobei das Gehäuse (1; 1') eine Tasche (1.31) aufweist,
**dadurch gekennzeichnet, dass**
das Kunststoffteil (1.3; 1.3') des Gehäuses (1; 1') die Tasche (1.31) aufweist, wobei zumindest an der äußeren Oberfläche eine erste Metallschicht (1.1) aufgebracht ist, die
- in einem ersten Flächenbereich (A1) eine erste Schichtdicke (d1) und
- in einem zweiten Flächenbereich (A2), der in der Tasche (1.31) angeordnet ist, eine zweite Schichtdicke (d2) aufweist, wobei
die zweite Schichtdicke (d2) größer ist als die erste Schichtdicke (d1) und das elektronische Bauteil (2.1) so im Gehäuse (1; 1') angeordnet ist, dass dieses mit dem zweiten Flächenbereich (A2) thermisch verbunden ist und eine Gerade (g) mit relativ zur Leiterplatte (2) orthogonalem Verlauf sowohl das elektronische Bauteil (2.1) als auch den zweiten Flächenbereich (A2) schneidet.

2. Elektrische Steckkupplungsvorrichtung gemäß dem Anspruch 1, wobei an der inneren Oberfläche des Gehäuses (1; 1') in einem dritten Flächenbereich (A3) eine zweite Metallschicht (1.2) aufgebracht ist, welche so angeordnet ist, dass die Gerade (g) auch den dritten Flächenbereich (A3) schneidet.

3. Elektrische Steckkupplungsvorrichtung gemäß dem Anspruch 2, wobei das elektronische Bauteil (2.1) ohne Luftspalt mit der inneren Oberfläche des Gehäuses (1; 1') im dritten Flächenbereich (A3) thermisch verbunden ist.

4. Elektrische Steckkupplungsvorrichtung gemäß einem der vorhergehenden Ansprüche, wobei zur thermischen Anbindung des elektronischen Bauteils (2.1) eine Wärmeleitpaste (3) zwischen dem elektronischen Bauteil (2.1) und der inneren Oberfläche des Gehäuses (1; 1') angeordnet ist.

5. Elektrische Steckkupplungsvorrichtung gemäß einem der vorhergehenden Ansprüche, wobei das Gehäuse (1') eine Ausnehmung aufweist, die mit thermisch leitfähigem Material (4) ausgefüllt ist, welches so angeordnet ist, dass die Gerade (g) auch dieses schneidet.

6. Elektrische Steckkupplungsvorrichtung gemäß dem Anspruch 5, wobei das thermisch leitfähige Material (4) das Kunststoffteil (1.3') vollständig durchdringt.

7. Elektrische Steckkupplungsvorrichtung gemäß einem der vorhergehenden Ansprüche, wobei die erste Metallschicht (1.1) galvanisch aufgebracht ist.

8. Elektrische Steckkupplungsvorrichtung gemäß einem der vorhergehenden Ansprüche, wobei die zweite Metallschicht (1.2) galvanisch aufgebracht ist.

9. Elektrische Steckkupplungsvorrichtung gemäß einem der vorhergehenden Ansprüche, wobei der zweite Flächenbereich (A2) parallel zur Leiterplatte (2) verläuft.

10. Elektrische Steckkupplungsvorrichtung gemäß einem der vorhergehenden Ansprüche, wobei der dritte Flächenbereich (A3) parallel zur Leiterplatte (2) verläuft.

11. Elektrische Steckkupplungsvorrichtung gemäß einem der vorhergehenden Ansprüche, wobei ein Abstand (y) zwischen der Leiterplatte (2) und der äußeren Oberfläche des Kunststoffteils (1.3) im Bereich der Tasche (1.31) kleiner ist als der Abstand (Y) in einem der Tasche (1.31) benachbarten Bereich des Kunststoffteils (1.3).

12. Elektrische Steckkupplungsvorrichtung gemäß einem der vorhergehenden Ansprüche, wobei das elektronische Bauteil (2.1) ein Spannungsregler ist, durch den eine Eingangsspannung auf eine niedrigere Ausgangsspannung regelbar ist, insbesondere zum Laden eines an die Steckkupplungsvorrichtung anschließbaren Akkumulators.

13. Elektrische Steckkupplungsvorrichtung gemäß einem der vorhergehenden Ansprüche, wobei die erste Schichtdicke (d1) der ersten Metallschicht (1.1) in dem ersten Flächenbereich (A1) zwischen 20 µm und 30 µm und die zweite Schichtdicke (d2) in dem zweiten Flächenbereich (A2) zwischen 25 µm und 40 µm beträgt.

14. Elektrische Steckkupplungsvorrichtung gemäß einem der vorhergehenden Ansprüche, wobei die zweite Schichtdicke (d2) mindestens 1,1-mal größer als die erste Schichtdicke (d1) ist.

15. Elektrische Steckkupplungsvorrichtung nach Anspruch 14, wobei die zweite Schichtdicke (d2) mindestens 1,25-mal größer ist als die erste Schichtdicke (d1).

## Claims

1. Electrical plug-in coupling apparatus comprising a housing (1; 1') and a printed circuit board (2), wherein
- the housing (1; 1') comprises a plastic part (1.3; 1.3') which has an inner surface and an outer surface,
- the printed circuit board (2) is fitted with at least one electronic component (2.1) and is arranged in the housing,
- wherein the housing (1; 1') has a pocket (1.31),
**characterized in that**
the plastic part (1.3; 1.3') of the housing (1; 1') has the pocket (1.31), wherein a first metal layer (1.1) is applied at least to the outer surface, which first metal layer has
- a first layer thickness (d1) in a first surface region (A1) and
- a second layer thickness (d2) in a second surface region (A2) which is arranged in the pocket (1.31), wherein
the second layer thickness (d2) is greater than the first layer thickness (d1) and
the electronic component (2.1) is arranged in the housing (1; 1') such that it is thermally connected to the second surface region (A2) and a straight line (g) with a profile which is orthogonal relative to the printed circuit board (2) intersects both the electronic component (2.1) and also the second surface region (A2).

2. Electrical plug-in coupling apparatus according to Claim 1, wherein a second metal layer (1.2) is applied to the inner surface of the housing (1; 1') in a third surface region (A3) and is arranged such that the straight line (g) also intersects the third surface region (A3).

3. Electrical plug-in coupling apparatus according to Claim 2, wherein the electronic component (2.1) is thermally connected to the inner surface of the housing (1; 1') in the third surface region (A3) without an air gap.

4. Electrical plug-in coupling apparatus according to one of the preceding claims, wherein a thermally conductive paste (3) is arranged between the electronic component (2.1) and the inner surface of the housing (1; 1') for thermal connection of the electronic component (2.1).

5. Electrical plug-in coupling apparatus according to one of the preceding claims, wherein the housing (1') has a recess which is filled with thermally conductive material (4) which is arranged such that the straight line (g) also intersects it.

6. Electrical plug-in coupling apparatus according to Claim 5, wherein the thermally conductive material (4) completely penetrates the plastic part (1.3').

7. Electrical plug-in coupling apparatus according to one of the preceding claims, wherein the first metal layer (1.1) is applied by electroplating.

8. Electrical plug-in coupling apparatus according to one of the preceding claims, wherein the second metal layer (1.2) is applied by electroplating.

9. Electrical plug-in coupling apparatus according to one of the preceding claims, wherein the second surface region (A2) runs parallel to the printed circuit board (2).

10. Electrical plug-in coupling apparatus according to one of the preceding claims, wherein the third surface region (A3) runs parallel to the printed circuit board (2).

11. Electrical plug-in coupling apparatus according to one of the preceding claims, wherein a distance (y) between the printed circuit board (2) and the outer surface of the plastic part (1.3) in the region of the pocket (1.31) is smaller than the distance (Y) in a region of the plastic part (1.3), which region is adjacent to the pocket (1.31).

12. Electrical plug-in coupling apparatus according to one of the preceding claims, wherein the electronic component (2.1) is a voltage controller by way of which an input voltage can be regulated at a lower output voltage, in particular for charging a rechargeable battery which can be connected to the plug-in coupling apparatus.

13. Electrical plug-in coupling apparatus according to one of the preceding claims, wherein the first layer thickness (d1) of the first metal layer (1.1) in the first surface region (A1) is between 20 µm and 30 µm and the second layer thickness (d2) in the second surface region (A2) is between 25 µm and 40 µm.

14. Electrical plug-in coupling apparatus according to one of the preceding claims, wherein the second layer thickness (d2) is at least 1.1 times greater than the first layer thickness (d1).

15. Electrical plug-in coupling apparatus according to Claim 14, wherein the second layer thickness (d2) is at least 1.25 times greater than the first layer thickness (d1).

## Revendications

1. Dispositif d'accouplement électrique enfichable comportant un boîtier (1 ; 1') et une carte de circuit imprimé (2), dans lequel
- le boîtier (1 ; 1') comprend une pièce en matière plastique (1.3 ; 1.3') ayant une surface intérieure et une surface extérieure,
- la carte de circuit imprimé (2) est pourvue d'au moins un composant électronique (2.1) et est disposée dans le boîtier,
- dans lequel le boîtier (1 ; 1') comprend une poche (1.31),
**caractérisé en ce que**
la pièce en matière plastique (1.3 ; 1.3') du boîtier (1 ; 1') comprend la poche (1.31), dans lequel une première couche métallique (1.1) est appliquée au moins sur la surface extérieure, laquelle couche métallique présente
- une première épaisseur de couche (d1) dans une première zone de surface (A1) et
- une deuxième épaisseur de couche (d2) dans une deuxième zone de surface (A2) qui est disposée dans la poche (1.31), dans lequel la deuxième épaisseur de couche (d2) est supérieure à la première épaisseur de couche (d1) et le composant électronique (2.1) est disposé dans le boîtier (1 ; 1') de telle manière qu'il est relié thermiquement à la deuxième zone de surface (A2) et qu'une ligne droite (g) s'étendant perpendiculairement par rapport à la carte de circuit imprimé (2) coupe à la fois le composant électronique (2.1) et la deuxième zone de surface (A2).

2. Dispositif d'accouplement électrique enfichable selon la revendication 1, dans lequel une deuxième couche métallique (1.2) est appliquée sur la surface intérieure du boîtier (1 ; 1') dans une troisième zone de surface (A3), laquelle deuxième couche métallique est disposée de telle manière que la ligne droite (g) coupe également la troisième zone de surface (A3).

3. Dispositif d'accouplement électrique enfichable selon la revendication 2, dans lequel le composant électronique (2.1) est relié thermiquement sans espace d'air à la surface intérieure du boîtier (1 ; 1') dans la troisième zone de surface (A3).

4. Dispositif d'accouplement électrique enfichable selon l'une des revendications précédentes, dans lequel une pâte thermiquement conductrice (3) est disposée entre le composant électronique (2.1) et la surface intérieure du boîtier (1 ; 1') pour la liaison thermique du composant électronique (2.1).

5. Dispositif d'accouplement électrique enfichable selon l'une des revendications précédentes, dans lequel le boîtier (1') présente un évidement rempli d'un matériau thermiquement conducteur (4), lequel évidement est disposé de telle manière que la ligne droite (g) le coupe également.

6. Dispositif d'accouplement électrique enfichable selon la revendication 5, dans lequel le matériau thermiquement conducteur (4) traverse entièrement la pièce en matière plastique (1.3').

7. Dispositif d'accouplement électrique enfichable selon l'une des revendications précédentes, dans lequel la première couche métallique (1.1) est appliquée par galvanisation.

8. Dispositif d'accouplement électrique enfichable selon l'une des revendications précédentes, dans lequel la deuxième couche métallique (1.2) est appliquée par galvanisation.

9. Dispositif d'accouplement électrique enfichable selon l'une des revendications précédentes, dans lequel la deuxième zone de surface (A2) est parallèle à la carte de circuit imprimé (2).

10. Dispositif d'accouplement électrique enfichable selon l'une des revendications précédentes, dans lequel la troisième zone de surface (A3) est parallèle à la carte de circuit imprimé (2).

11. Dispositif d'accouplement électrique enfichable selon l'une des revendications précédentes, dans lequel une distance (y) entre la carte de circuit imprimé (2) et la surface extérieure de la pièce en matière plastique (1.3) dans la zone de la poche (1.31) est inférieure à la distance (Y) dans une zone de la pièce en matière plastique (1.3) qui est adjacente à la poche (1.31).

12. Dispositif d'accouplement électrique enfichable selon l'une des revendications précédentes, dans lequel le composant électronique (2.1) est un régulateur de tension au moyen duquel une tension d'entrée peut être régulée à une tension de sortie inférieure, en particulier pour charger un accumulateur qui peut être connecté au dispositif d'accouplement enfichable.

13. Dispositif d'accouplement électrique enfichable selon l'une des revendications précédentes, dans lequel la première épaisseur de couche (d1) de la première couche métallique (1.1) dans la première zone de surface (A1) est comprise entre 20 µm et 30 µm et la deuxième épaisseur de couche (d2) dans la deuxième zone de surface (A2) est comprise entre 25 µm et 40 µm.

14. Dispositif d'accouplement électrique enfichable selon l'une des revendications précédentes, dans lequel la deuxième épaisseur de couche (d2) est au moins 1,1 fois supérieure à la première épaisseur de couche (d1).

15. Dispositif d'accouplement électrique enfichable selon la revendication 14, dans lequel la deuxième épaisseur de couche (d2) est au moins 1,25 fois supérieure à la première épaisseur de couche (d1).
